# EUROPÄISCHE PATENTSCHRIFT

(11) **EP 2 228 845 B1**
(45) Veröffentlichungstag und Bekanntmachung des Hinweises auf die Patenterteilung: **29.02.2012**
(21) Anmeldenummer: 10005054.1
(22) Anmeldetag: 21.07.2004
(51) Int. Cl.: H01L 41/053, F02M 51/06

(54) **Einspritzventil mit einem piezoelektrischen Aktor mit verbesserter Langzeitstabilität**
Injection valve with a piezoelectric actuator having improved long-time stability
Soupape d'injection avec un actionneur piézo-électrique ayant une stabilité de longue durée améliorée

(43) Veröffentlichungstag der Anmeldung: 15.09.2010
(62) Teilanmeldung aus: 04017194.4
(73) Patentinhaber: Continental Automotive GmbH, 30165 Hannover (DE)
(72) Erfinder: Denzler, Michael, 93055 Regensburg (DE); Kohn, Stefan, 92277 Hohenburg (DE); Neumaier, Martin, 84424 Isen (DE); Niefanger, Roland, 38557 Osloß (DE); Plecher, Klaus, 93197 Zeitlarn (DE); Voigt, Andreas, 93133 Burglengenfeld (DE); Zumstrull, Claus, 93128 Regenstauf (DE)

(56) Entgegenhaltungen:
- DE-A1- 10 244 614
- DE-A1- 19 818 036
- US-A- 5 295 288

## Beschreibung

Die Erfindung betrifft ein Einspritzventil mit einem piezoelektrischen Aktor gemäß Anspruch 1.

Piezoelektrische Aktoren werden in den verschiedensten technischen Bereichen eingesetzt, um eine schnelle und präzise Betätigung eines Stellglieds erreichen zu können. Ein bevorzugter Einsatz der piezoelektrischen Aktoren ist beispielsweise in der Kraftfahrzeugtechnik in einem Einspritzventil, in dem der piezoelektrische Aktor die Einspritzung steuert. Dabei wird vorzugsweise die hohe Dynamik und schnelle Steuerbarkeit des piezoelektrischen Aktors eingesetzt.

Piezoelektrische Aktoren weisen wenigstens ein piezoelektrisches Element auf, das zwischen zwei Elektroden angeordnet ist. Durch ein Anlegen einer Spannung an die zwei Elektroden wird die Dicke des piezoelektrischen Elements verändert und somit eine Betätigung eines Stellglieds ermöglicht. Da jedoch die Längung oder Verkürzung des piezoelektrischen Aktors in Abhängigkeit von der angelegten Spannung relativ klein ist, wird bei Einspritzventilen als piezoelektrischer Aktor ein Stapel von einer Vielzahl von piezoelektrischen Elementen eingesetzt, die jeweils zwischen zwei Elektroden angeordnet sind. Die Elektroden sind vorteilhaft über Drähte mit zwei Kontaktstiften elektrisch leitend verbunden. Der Stapel, die Drähte und die Kontaktstifte werden beispielsweise in eine entsprechende Ausnehmung eines zylinderförmigen Kunststoffgehäuses eingebracht. Anschließend wird die Ausnehmung mit einer Vergussmasse aufgefüllt. Damit wird der Stapel mit der Vergussmasse umhüllt und gegen Umwelteinflüsse geschützt. Zudem sind die Elektroden, die einen geringen Abstand voneinander haben, elektrisch isoliert. Weiterhin wird dadurch eine feste Halterung des Stapels in dem Kunststoffgehäuse erreicht. Die Vergussmasse besteht beispielsweise aus Silikon.

Entsprechende piezoelektrische Aktoren sind beispielsweise aus der Patentanmeldung DE 102 29 494 A1 oder aus der Patentschrift DE 198 44 742 C1 bekannt.

Aus der DE 198 18 036 A1 ist zudem ein piezoelektrischer Aktor mit einer piezoelektrischen Keramik, die mit einer Vergussmasse umgeben ist, bekannt. Diese Vergussmasse weist einen Haftungsvermittler auf, welcher Wasserstoffbrückenbindungen aufbaut.

Die Aufgabe der Erfindung besteht darin, ein Einspritzventil bereitzustellen, das eine erhöhte Langzeitstabilität aufweist.

Die Aufgabe der Erfindung wird durch ein Einspritzventil gemäß Patentanspruch 1 gelöst.

Vorteilhafte Ausführungsformen der Erfindung sind in den abhängigen Ansprüchen angegeben.

Ein Vorteil der Erfindung besteht darin, dass die chemische Reaktion zwischen dem reduzierenden Stoff der Vergussmasse und der piezoelektrischen Keramik vermindert oder sogar vermieden wird.

In einer weiteren Ausführungsform besteht ein Vorteil des erfindungsgemäßen Verfahrens darin, dass die Reaktionshäufigkeit zwischen dem Sauerstoff der Keramik und einem reduzierenden Stoff der Vergussmasse gesenkt wird. Versuche haben gezeigt, dass verwendete Vergussmassen eine reduzierende Atmosphäre schaffen, die mit dem Sauerstoff der Keramik reagiert und den Sauerstoff aus der Keramik löst. Bei der Verwendung einer Vergussmasse, die beispielsweise Wasserstoff enthält, sind nicht alle Wasserstoffatome vollständig gebunden, sondern weisen freie Bindungen auf. Der Wasserstoff versucht, chemische Bindungen einzugehen. Dabei bietet sich der Sauerstoff der piezoelektrischen Keramik an. Durch den chemischen Ausbau der in der Piezokeramik gebundenen Sauerstoffatome nimmt die Sauerstoff-Leerstellenleitung zu. Dies führt dazu, dass die elektrische Leitfähigkeit der piezoelektrischen Keramik erhöht wird. Dies wiederum führt zu mechanischen Rissen und elektrischen Spannungsüberschlägen zwischen den Elektroden der piezoelektrischen Elemente. Damit wird insgesamt die Langzeitstabilität des piezoelektrischen Aktors reduziert. Durch die offenbarten Maßnahmen wird die Reaktionshäufigkeit des reduzierenden Stoffes, beispielsweise des Wasserstoffs der Vergussmasse mit dem Sauerstoff der piezoelektrischen Keramik vermindert. Auf diese Weise wird die Qualität des piezoelektrischen Aktors erhöht.

Eine nicht beanspruchte Ausführungsform des Verfahrens besteht darin, dass eine Vergussmasse verwendet wird, in der ein chemisch reduzierender Stoff nur mit einer vorgegebenen maximalen Konzentration enthalten ist. Vorzugsweise wird eine Vergussmasse verwendet, die als reduzierenden Stoff Wasserstoff in Form von Silan enthält, wobei jedoch die Konzentration von Silan kleiner als 1 Gewichtsprozent ist. Aufgrund der geringen Konzentration von Silan und damit der geringen Konzentration von Wasserstoff wird die Reaktionshäufigkeit zwischen dem Sauerstoff der piezoelektrischen Keramik und dem Wasserstoff deutlich gesenkt. Silan hat in der Vergussmasse die Aufgabe eines Haftvermittlers, so dass die Haftfähigkeit zwischen der Oberfläche der piezoelektrischen Keramik und der verwendeten Vergussmasse, die beispielsweise Silikon aufweist, erhöht wird. Für eine ausreichende Haftvermittlung zwischen der Oberfläche der piezoelektrischen Keramik und dem Silikon ist eine gewisse Mindestmenge von Silan erforderlich. Jedoch führt ein Überangebot von Silan dazu, dass Wasserstoff mit chemisch freien Bindungen in der Vergussmasse vorhanden ist. Da sich der Haftvermittler an der Oberfläche der Keramik absetzt, besteht die Gefahr, dass die ungesättigten Bindungen des Wasserstoffs mit dem Sauerstoff der piezoelektrischen Keramik chemische Bindungen eingehen. Durch die Reduzierung der Konzentration der Wasserstoffatome und insbesondere durch die Reduzierung der Konzentration von Silan wird der Auslösevorgang von Sauerstoff aus der piezoelektrischen Keramik abgeschwächt.

In einer weiteren nicht beanspruchten Ausführungsform des Verfahrens wird nach Umgießen des piezoelektrischen Aktors mit der Vergussmasse durch einen Wärmeprozess die Konzentration des reduzierenden Stoffes und/oder die Konzentration der Reaktionspartner, die den reduzierenden Stoff bilden, in der Vergussmasse gesenkt. Damit wird die Menge des für eine Reaktion mit dem Sauerstoff der piezoelektrischen Keramik zur Verfügung stehenden reduzierenden Stoffs verkleinert. Somit können weniger Sauerstoffatome der piezoelektrischen Keramik mit dem reduzierenden Stoff der Vergussmasse chemische Bindungen eingehen.

Vorzugsweise wird die Konzentration des reduzierenden Stoffs, insbesondere Wasserstoff mit dem Wärmeprozess unter eine vorgegebene Schwelle abgesenkt. Somit wird eine vorgegebene Qualität des piezoelektrischen Aktors eingestellt, die eine erhöhte Langzeitstabilität bewirkt.

In einer erfindungsgemäßen Ausführungsform wird der piezoelektrische Aktor in ein Gehäuse, insbesondere in ein Gehäuse eines Einspritzventils eingebaut, in dem Mittel zum Zuführen von Sauerstoff zur Vergussmasse vorgesehen sind. Durch das Anbieten von freiem Sauerstoff wird die Reaktionshäufigkeit der ungesättigten Bindungen des reduzierenden Stoffs, insbesondere des Wasserstoffs der Vergussmasse mit dem Sauerstoff der piezoelektrischen Keramik reduziert. Zudem kann eine Membran eingesetzt werden, um Sauerstoff in das Gehäuse einzuführen.

In einer weiteren erfindungsgemäßen Ausführungsform weist das Gehäuse Mittel zum Abführen des reduzierenden Stoffs, insbesondere von Wasserstoff auf. Das Mittel kann beispielsweise in Form einer Membran ausgebildet sein, das ein Entweichen des reduzierenden Stoffs aus dem Gehäuse ermöglicht.

In einer weiteren nicht beanspruchten Ausführungsform ist im Gehäuse ein zweiter Stoff vorgesehen, der bestrebt ist, Bindungen mit dem reduzierenden Stoff der Vergussmasse einzugehen. Auch auf diese Weise werden die freien Bindungen des reduzierenden Stoffs der Vergussmasse belegt, so dass eine Reaktion des reduzierenden Stoffs mit dem Sauerstoff der piezoelektrischen Keramik verhindert wird.

Die Erfindung wird im folgenden anhand der Figuren näher erläutert. Es zeigen
Figur 1 eine schematische Darstellung eines piezoelektrischen Aktors, der über eine Vergussmasse in einer Kunststoffhülse befestigt ist, und
Figur 2 einen Teilausschnitt eines Einspritzventils mit einem Gehäuse, in dem der piezoelektrische Aktor eingebracht ist.

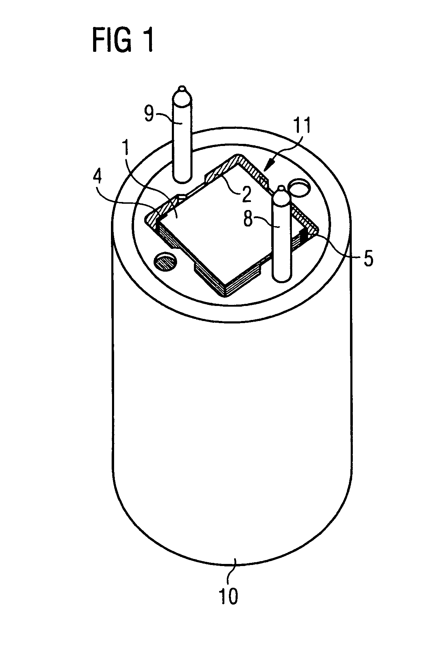

Figur 1 zeigt in einer perspektivischen Darstellung einen piezoelektrischen Aktor 1, der aus einem Stapel von piezoelektrischen Elementen aufgebaut ist, wobei jedes piezoelektrische Element zwischen zwei Elektroden angeordnet ist. Die Elektroden sind abwechselnd zu einem ersten oder zweiten Leiterstreifen 4, 5 geführt, die an gegenüberliegenden Eckbereichen des quadratisch geformten piezoelektrischen Aktors 1 angeordnet sind. Der erste und der zweite Leiterstreifen 4, 5 sind über Leiterfolien an Kontaktstifte 8, 9 angeschlossen. Auf diese Weise ist der erste Kontaktstift 8 elektrisch leitend mit einer ersten Hälfte der Elektroden 3 verbunden. Der zweite Kontaktstift 9 ist mit der anderen Hälfte der Elektroden 3 elektrisch leitend verbunden. Der vormontierte piezoelektrische Aktor 1 mit den Leiterfolien und den Kontaktstiften 8, 9 wird in eine Kunststoffhülse 10 eingebracht, die eine entsprechende Ausnehmung 11 aufweist. Anschließend wird die Ausnehmung 11 mit einer Vergussmasse 2 aufgefüllt, so dass eine Halterung des piezoelektrischen Aktors 1 in der Kunststoffhülse 10 erreicht wird. Die Vergussmasse 2 besteht beispielsweise aus Silikon. Die piezoelektrischen Elemente bestehen aus einer piezoelektrischen Keramik, die Sauerstoff enthält.

Die Vergussmasse 2 wird dazu verwendet, um den piezoelektrischen Aktor 1 dicht zu ummanteln, so dass weder Feuchtigkeit, noch Kraftstoff oder Öl an die piezoelektrischen Elemente gelangen können. Zudem dient die Vergussmasse 2 zur elektrischen Isolierung der Elektroden und zur Abführung von Wärme. In Abhängigkeit von der verwendeten Ausführungsform kann auch auf die Kunststoffhülse 10 verzichtet werden.

Vorzugsweise wird eine Vergussmasse 2 verwendet, die einen chemisch reduzierenden Stoff enthält, der bestrebt ist, chemische Bindungen mit dem Sauerstoff der piezoelektrischen Keramik einzugehen. Beispielsweise wird eine Vergussmasse verwendet, die einen reduzierenden Stoff bildet. Beispielsweise kann eine reduzierende Gasatmosphäre durch ein Aushärten oder Nebenreaktionen der Vergussmasse gebildet werden. Beispielsweise wird eine Vergussmasse verwendet, die einen Haftvermittler in Form von Silan und damit Wasserstoff enthält. Vorzugsweise ist die Konzentration von Silan kleiner als 1 Gewichtsprozent. Somit ist relativ wenig Wasserstoff in der Vergussmasse 2 enthalten, so dass die Reaktionshäufigkeit zwischen dem Sauerstoff der piezoelektrischen Elemente und dem Wasserstoff der Vergussmasse 11 reduziert ist. Es können jedoch auch Vergussmassen 2 mit anderen reduzierenden Stoffen verwendet werden, deren Konzentrationen entsprechend niedrig gehalten ist.

In Abhängigkeit von der verwendeten Vergussmasse wird eine möglichst geringe Konzentration an Wasserstoff verwendet. Bei der Verwendung eines Haftvermittlers in der Vergussmasse 11 werden vorzugsweise Konzentrationen zwischen 0,5 und 0,25 Gewichtsprozent des Haftvermittlers verwendet. Diese Konzentrationen werden auch bevorzugt bei Silan als Haftvermittler verwendet.

In einer weiteren vorteilhaften Ausführungsform wird nach dem Vergießen des piezoelektrischen Aktors 1 in der Kunststoffhülse 10 ein Wärmeprozess mit erhöhter Temperatur durchgeführt. Der Wärmeprozess wird vorzugsweise so lange durchgeführt, bis nur noch eine vorgegebene Konzentration des reduzierenden Stoffes, in diesem Fall Wasserstoff in der Vergussmasse vorliegt. In einer weiteren Ausführungsform kann auch die Konzentration der Reaktionspartner, die den reduzierenden Stoff bilden, durch den Wärmeprozess reduziert werden. Die einzustellende Konzentrationen von Wasserstoff wird zuvor experimentell ermittelt. Für die Durchführung des Wärmeprozesses werden Temperaturen von über 120° C eingesetzt. Vorzugsweise wird während des Wärmeprozesses der Druck abgesenkt auf Werte von bis zu 2-3 mbar. Für die Durchführung des Wärmeprozesses eignet sich die Verwendung einer Niederdruckkammer, in der der umgossene piezoelektrische Aktor 1 angeordnet ist.

In einer weiteren bevorzugten Ausführungsform weist die Vergussmasse einen zweiten Stoff auf, der mit dem reduzierenden Stoff der Vergussmasse chemische Bindungen eingeht. Vorzugsweise enthält der zweite Stoff Sauerstoff für eine Reaktion mit ungesättigten Bindungen des reduzierenden Stoffes, insbesondere mit Wasserstoff der Vergussmasse.

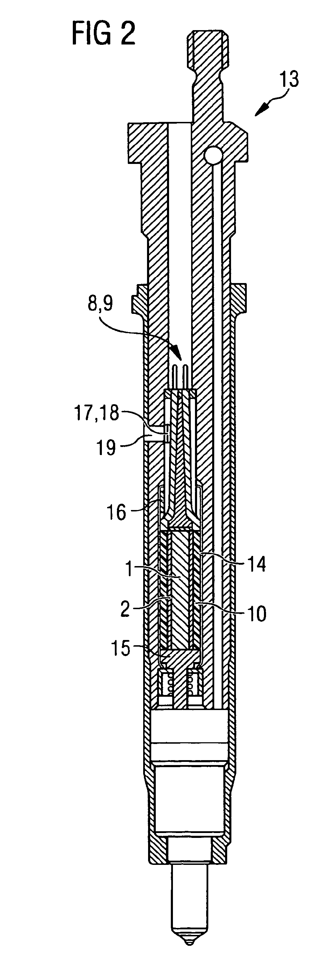

Figur 2 zeigt einen Teilausschnitt eines Einspritzventils 13 mit einem Gehäuse 14, in dem der piezoelektrische Aktor 1 in der Kunststoffhülse 10 eingebaut ist und in Wirkverbindung mit einem Stellglied 15 steht. In Abhängigkeit von der Bestromung des piezoelektrischen Aktors 1 wird die Position des Stellglieds 15 von dem piezoelektrischen Aktor 1 verändert. Das Stellglied 15 kann beispielsweise in Form eines Servoventils oder in Form einer Einspritznadel ausgebildet sein. Vorzugsweise ist im Gehäuse der zweite Stoff 16 angeordnet, der beispielsweise Sauerstoff für eine Reaktion mit ungesättigten Bindungen des Wasserstoffs der Vergussmasse 2 bereitstellt.

In einer erfindungsgemäßen Ausführungsform weist das Gehäuse 14 ein Öffnung 17 auf, in der eine Membran 18 angeordnet ist. Die Öffnung 17 ist an einen Kanal 19 angeschlossen. Die Membran 18 weist in einer ersten Ausführungsform die Eigenschaft auf, den reduzierenden Stoff, insbesondere Wasserstoff aus dem Gehäuse 14 entweichen zu lassen. In einer zweiten Ausführungsform weist die Membran 18 die Eigenschaft auf, einen reduzierbaren Stoff, insbesondere Sauerstoff aus dem Kanal 19 in das Gehäuse 14 eindringen zu lassen. In Abhängigkeit von der Umgebung des Gehäuses 14 wird die Membran 18 gasdurchlässig, öldicht und wasserdicht ausgebildet. Auf diese Weise ist ein Zuführen von Sauerstoff in das Gehäuse 14 möglich, ohne dass Öl oder Feuchtigkeit in das Gehäuse 14 eindringt.

Durch die erfindungsgemäße Lehre wird die Menge des aus der piezoelektrischen Keramik gelösten Sauerstoffs reduziert, so dass die Langzeitstabilität des piezoelektrischen Aktors erhöht wird.

## Patentansprüche

1. Einspritzventil mit einem piezoelektrischen Aktor mit einer piezoelektrischen Keramik, die mit einer Vergussmasse (2) umgeben ist, welche einen chemisch reduzierenden Stoff enthält, der chemische Bindungen mit dem Sauerstoff der piezoelektrischen Keramik eingeht, insbesondere Wasserstoff enthält oder bildet, wobei der piezoelektrische Aktor (1) in ein Gehäuse (14) des Einspritzventils (13) eingebaut ist, **dadurch gekennzeichnet, dass** Mittel (17, 18, 19) im Gehäuse (14) vorgesehen sind, mit denen der von der Vergussmasse (2) abgegebene reduzierende Stoff, der mit Sauerstoff chemische Bindungen eingeht, insbesondere Wasserstoff, aus dem Gehäuse (14) des Einspritzventils (13) abführbar ist, und/oder Sauerstoff der Vergussmasse (2) zuführbar ist.

2. Einspritzventil nach Anspruch 1, **dadurch gekennzeichnet, dass** die Mittel als Membran (18) im Gehäuse (14) ausgebildet sind, durch die die entsprechenden Stoffe entweichen und/oder zugeführt werden können.

## Claims

1. Injection valve having a piezoelectric actuator consisting of a piezoelectric ceramic which is encased in a potting compound (2) which contains a chemically reductive substance, in particular which contains or forms hydrogen, which reductive substance establishes chemical bonds with the oxygen of the piezoelectric ceramic, wherein the piezoelectric actuator (1) is installed in a housing (14) of the injection valve (13), **characterised in that** means (17, 18, 19) are provided in the housing (14) to enable the reductive substance, in particular hydrogen, which is released from the potting compound (2) and which establishes chemical bonds with oxygen, to be dissipated from the housing (14) of the injection valve (13), and/or oxygen to be supplied to the potting compound (2).

2. Injection valve according to claim 1, **characterised in that** the means are embodied in the form of a membrane (18) in the housing (14), through which membrane (18) the corresponding substances are able to escape and/or be supplied.

## Revendications

1. Soupape d'injection avec un actionneur piézoélectrique avec une céramique piézoélectrique, qui est entourée d'une masse de scellement (2), laquelle contient une substance chimiquement réductrice, qui établit des liaisons chimiques avec l'oxygène de la céramique piézoélectrique, et en particulier contient ou forme de l'hydrogène, dans laquelle l'actionneur piézoélectrique (1) est incorporé à un boîtier (14) de la soupape d'injection (13), **caractérisée en ce que** l'on prévoit dans le boîtier (14) des moyens (17, 18, 19), à l'aide desquels la substance réductrice délivrée par la masse de scellement (2), qui forme des liaisons chimiques avec de l'oxygène, en particulier de l'hydrogène, peut être évacué du boîtier (14) de la soupape d'injection (13) et/ou de l'oxygène peut être acheminé jusqu'à la masse de scellement (2).

2. Soupape d'injection selon la revendication 1, **caractérisée en ce que** les moyens se présentent sous la forme d'une membrane (18) dans le boîtier (14), à travers laquelle membrane les substances correspondantes peuvent s'échapper et/ou être acheminées.
